# EUROPÄISCHE PATENTSCHRIFT

(11) **EP 0 637 089 B1**
(45) Veröffentlichungstag und Bekanntmachung des Hinweises auf die Patenterteilung: **14.05.1997**
(21) Anmeldenummer: 94110936.5
(22) Anmeldetag: 14.07.1994
(51) Int. Cl.: H01L 41/24, C04B 35/491

(54) **Verfahren zur Herstellung von PZT-Schichten**
Method of making PZT layers
Procédé de fabrication des couches PZT

(30) Priorität: 27.07.1993 DE 4325167
(43) Veröffentlichungstag der Anmeldung: 01.02.1995
(73) Patentinhaber: MAN Roland Druckmaschinen AG, 63012 Offenbach (DE)
(72) Erfinder: Gesemann, Hans-Jürgen, Dr., D-09130 Chemnitz (DE); Seffner, Lutz, Dr., D-01109 Dresden (DE); Völker, Karin, D-01689 Weinböhla (DE)
(74) Vertreter: Schober, Stefan

(56) Entgegenhaltungen:
- EP-A- 0 338 799
- EP-A- 0 526 048
- US-A- 4 812 426

## Beschreibung

Die Erfindung bezieht sich auf die Gebiete des Maschinenbaus und der Dickschichttechnik und betrifft ein Verfahren zur Herstellung von PZT-Schichten, wie sie z.B. bei der Beschichtung von Druckwalzen zur Anwendung kommen.

Dünne Schichten auf der Basis von Bleititanatzirkonat (PZT) werden auf verschiedenen Trägermaterialien hergestellt. Zu diesen Trägermaterialien gehören Si, Al₂O₃, ZrO₂ u.a. Die dünnen PZT-Schichten werden für Speicherzwecke verwendet oder sie dienen wissenschaftlichen Zwecken.
Die Herstellung solcher Schichten erfolgt über verschiedene Verfahren. Die wichtigsten Verfahren zur Herstellung solcher PZT-Schichten sind das Sputterverfahren und das Sol-Gel-Verfahren. So hergestellte Schichten haben eine Schichtdicke im Bereich von 1 µm.

Aus der EP 0 338 799 A2 ist ein Sol-Gel-Verfahren zur Herstellung von PZT-Keramiken mit Perowskit-Struktur bekannt. Diese Keramiken werden bei Temperaturen bis zu 1500° C gesintert und sind nur zur Bildung dünner Schichten geeignet.

Dicke Schichten auf Trägermaterialien, wie z.B. Al₂O₃-Substrate, existieren noch nicht, obwohl Interesse daran besteht. Man kann sogar sagen, daß die Verfahren der Dickschichttechnik auf PZT-Versätze nicht angewendet werden können. Das hat Ursachen, die in den Eigenschaften des PZT begründet sind. Zwei Hindernisse stehen der Nutzung von PZT in Dickschichttechnik entgegen.

Einerseits führen die tradidionell hohen Sintertemperaturen von ca. 1200 ^{o}C beim Einbrand der Schichten zu einem hohen PbO-Verlust. Dieser PbO-Verlust tritt bevorzugt an der Oberfläche auf und führt dazu, daß die Eigenschaften des PZT vollständig verändert werden.

Andererseits bringt der Effekt der Querkontraktion Schwierigkeiten bei der Benutzung mit sich. Es liegt im Wesen des Piezoeffektes, daß beim Anlegen einer Spannung eine Dehnung in Richtung der Polarisation und des Feldes erfolgt. Senkrecht zu diesem Effekt tritt eine Querkontraktion auf. Das bedeutet, daß sich die aufgebrachte Schicht auf der Unterlage zusammenzieht, was bei der vorliegenden festen Haftung nur bedingt möglich ist. Die auftretenden Kräfte könne sehr groß sein und bis zur Verbiegung des Substrates oder zur Abplatzung der Schicht führen.

Der Erfindung liegt die Aufgabe zugrunde, die PbO-Verdampfung und die Querkontraktion bei PZT-Schichten zu vermindern, so daß derartige PZT-Schichten mit Methoden der Dickschichttechnik auf Unterlagen aufgebracht werden können und somit haftfeste piezoelektrische Schichten bis zu einer Dicke von 300 µm hergestellt werden können.

Die Aufgabe wird durch die in den Ansprüchen angegebene Erfindung gelöst.

Die Erfindung besteht in einem Verfahren zur Herstellung von PZT-Schichten durch Dickschichttechnik auf einem Träger. Die dabei entstehenden PZT-Schichten enthalten einfach modifiziertes PZT und/oder PZT mit Komplexperowskit. Erfindungsgemäß wird das PZT mit einem Zr-Gehalt X von X ≥ Xₚ + 0,02 ≤ Xₚ + 0,10, wobei Xₚ der Zr-Gehalt der Grundzusammensetzung an der morphotropen Phasengrenze ist, die durch das Kᵣ-Maximum bestimmt wird, eingesetzt.

Vorteilhafterweise wird als PZT ein weiches PZT mit einer remanenten Polarisation Pᵣ bei 50 Hz von ≥ 5 µC/cm² eingesetzt.

Ebenfalls vorteilhafterweise wird ein PZT mit einer Sintertemperatur von ≤ 1050 °C eingesetzt.

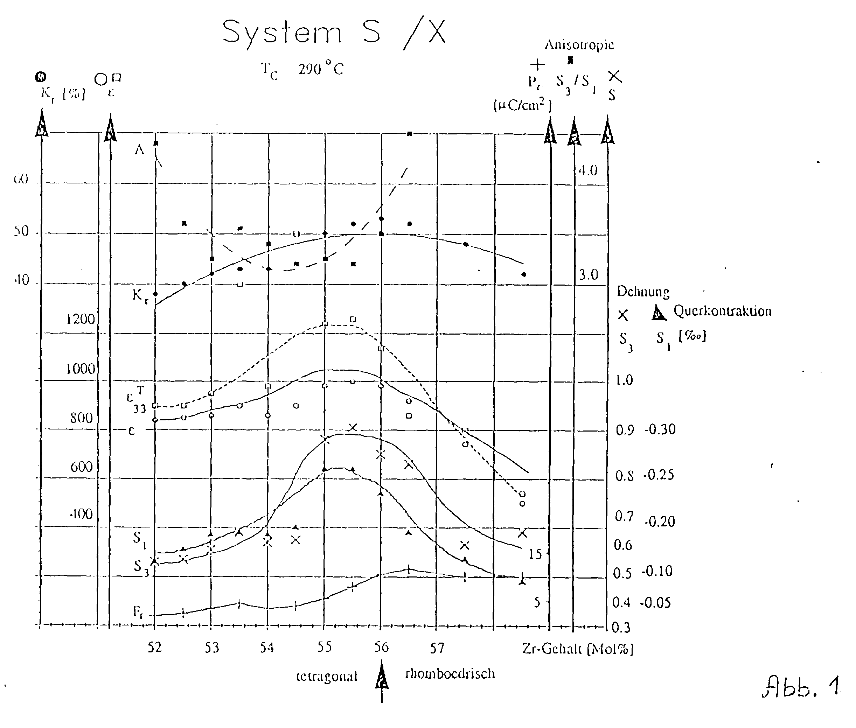

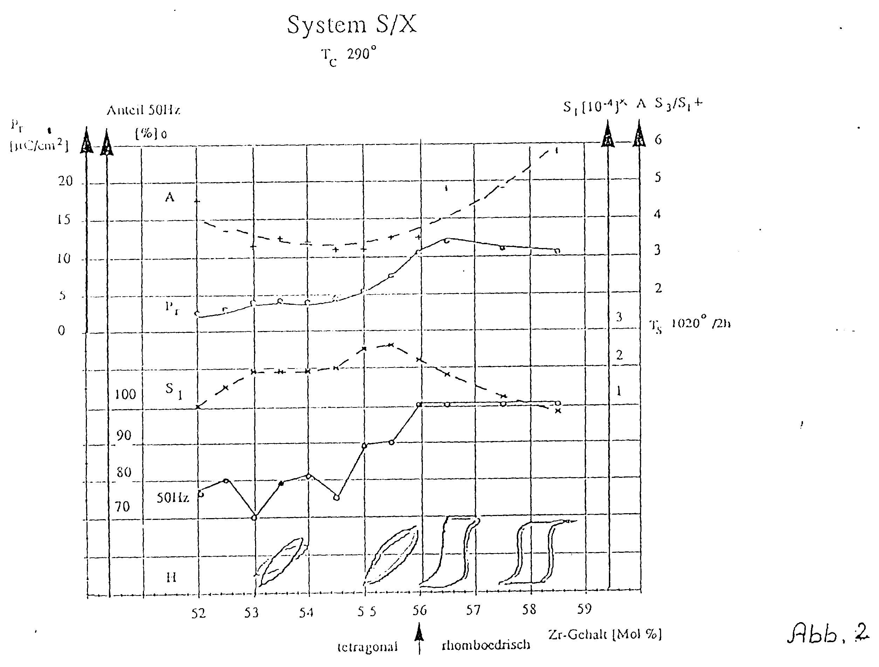

Das zur erfindungsgemäßen Herstellung von PZT-Schichten eingesetzte einfach modifizierte PZT und/oder PZT mit Komplexperowskit zeigt als ternäres System im Phasendiagramm eine morphotrope Phasengrenze tetragonal - rhomboedrisch (pseudokubisch). Diese Phasengrenze kann sich je nach Zusammensetzung in ihrer Lage quantitativ verändern, aber das qualitative Verhalten bleibt immer gleich. In der Nähe dieser morphotropen Phasengrenze zeigen die Piezodaten ein charakteristisches Verhalten. Dieses charakeristische Verhalten ist an einem Modellsystem S/X ermittelt und in den Abbildungen 1 und 2 dargestellt. Aus diesen Abbildungen ist zu erkennen, daß wichtige Piezoeigenschaften, wie der Koppelfaktor Kᵣ, die ungepolte DK εᵣ, die gepolte DK ε^{T}₃₃, die Dickendehnung S₃, die Querkontraktion S₁ und die remanente Polarisation Pᵣ in der Nähe dieser Phasengrenze ein Maximum besitzen. Dieser Zusammenhang an sich ist bekannt.

Völlig überraschend ist jedoch, daß die Querkontraktion S₁ im rhomboedrischen Gebiet im Verhältnis zur Dickendehnung S₃ schnell abnimmt, so daß ein hohes Anisotropieverhältnis A von über 7 entsteht.

Weiterhin ist überraschend, daß parallel zum hohen Anisotropieverhältnis die remanente Polarisation Pᵣ bei Kurzzeitpolung relativ hoch bleibt.
Und ebenfalls überraschend ist, daß die Hysteresekurve bei 50 Hz fast identisch mit der Hysteresekurve bei 25 H_{z} ist, wodurch die erfindungsgemäßen Materialien äußerst leicht im Kurzzeitbereich polbar sind.
Aus den Abbildungen ist zu erkennen, daß diese vorteilhaften Eigenschaften nur in einem schmalen Bereich um die Phasengrenze gemeinsam auftreten.

Im weiteren wird die Erfindung an einem Ausführungsbeispiel näher erläutert.

Auf einem Al₂O₃-Substrat wird ein Komplexperowskit der Zusammensetzung Pb(Zr_{X}Ti_{0,795-X}(Zn_{1/2}W_{1/2})_{0,067}(Zn_{1/3}Nb_{2/3})_{0,138})O₃ + Z, wobei für Z 1 Gew-% NiO und für X 42 Mol-% eingesetzt wird, in Form von Schlicker oder Paste aufgebracht und bei 1050 ^{o}C 1 Stunde eingebrannt und mit einer Deckelektrode versehen.
Der Wert von X ist vorab ermittelt worden, indem mehrere Versätze des Komplexperowskits mit einem X-Gehalt von 38,5 bis 40 Mol-%, gestaffelt um 0,5 Mol-%, hergestellt worden sind und an ihnen der Koppelfaktor Kᵣ gemessen worden ist. Der Kᵣ-Wert erreichte bei X = 39,5 Mol-% ein Maximum. Dazu wurden mindestens 2 Mol-% dazugerechnet und der X-Wert erhalten, der in den Versatz eingesetzt worden ist.
Die so hergestellte Schicht zeigt folgende Eigenschaften:

| | |
|---|---|
| ε^{T}₃₃ | 800 |
| Pᵣ(statisch) | 10,7 µC/cm² (2 kV/mm Aussteuerung) |
| Pᵣ₅₀(50Hz) | 10,7 µC/cm² (2 kV/mm Aussteuerung) |
| Koerzitivfeldstärke | 800 V/mm |
| S₃-Wert | 5 x 10⁻⁴ |
| Querkontraktion S₁ | 8 x 10⁻⁵ (an einer Scheibe gemessen) |
| Haftfestigkeit | beim Polen gegeben |

## Patentansprüche

1. Verfahren zur Herstellung von Bleititanatzirkonat(PZT)-Schichten durch Dickschichttechnik auf einem Träger, bei dem die Bleititanatzirkonat-Schichten einfach modifiziertes Bleititanatzirkonat und/oder Bleititanatzirkonat mit Komplexperowskit enthalten, dadurch gekennzeichnet, daß Bleititanatzirkonat mit einem Zirkon-Gehalt X von X ≥ Xₚ + 0,02 ≤ Xₚ + 0,10 eingesetzt wird, wobei Xₚ der Zirkon-Gehalt der Grundzusammensetzung an der morphotropen Phasengrenze ist, die durch das Maximum des Koppelfaktors bestimmt wird.

2. Verfahren nach Anspruch 1, dadurch gekennzeichnet, daß als PZT ein weiches PZT mit einer remanenten Polarisation Pᵣ bei 50 Hz von ≥ 5 µC/cm² eingesetzt wird.

3. Verfahren nach Anspruch 1, dadurch gekennzeichnet, daß ein PZT mit einer Sintertemperatur von ≤ 1050 °C eingesetzt wird.

4. Verfahren nach einem der Ansprüche 1 bis 3, dadurch gekennzeichnet, daß ein Aluminiumoxid-Substrat als Trägermaterial der Bleititanatzirkonat-Schicht verwendet wird.

## Claims

1. Process for the production of lead titanate zirconate (PZT) layers by thick-film technology on a carrier, in which the lead titanate zirconate layers contain simply modified lead titanate zirconate and/or lead titanate zirconate with complex perovskite, characterised in that lead titanate zirconate with a zirconium content X of X ≥ Xₚ + 0.02 ≤ Xₚ + 0.10 is used, where Xₚ is the zirconium content of the basic composition at the morphotropic phase boundary, determined by the maximum of the coupling factor.

2. Process according to claim 1, characterised in that a soft PZT with a residual polarisation Pᵣ at 50 Hz of ≥ 5 µC/cm² is used.

3. Process according to claim 1, characterised in that a PZT with a sintering temperature of ≤ 1050°C is used.

4. Process according to one of claims 1 to 3, characterised in that an aluminium oxide substrate is used as the carrier material for the lead titanate zirconate layer.

## Revendications

1. Procédé pour fabriquer des couches de titanate - zirconate de plomb (PZT) sur un support à l'aide d'une technique à couches épaisses, selon lequel les couches de titanate - zirconate de plomb contiennent du titanate - zirconate de plomb modifié de façon simple et/ou du titanate - zirconate de plomb contenant de la pérovskite complexe, caractérisé en ce qu'on utilise du titanate - zirconate de plomb ayant une teneur X en zirconium telle que X≥Xₚ+0,02≤Xₚ+0,10, Xₚ désignant la teneur en zirconium de la composition de base au niveau de l'interface morphotrope, qui est déterminée par le maximum du facteur de couplage.

2. Procédé selon la revendication 1, caractérisé en ce qu'on utilise comme PZT un PZT mou ayant une polarisation rémanente Pᵣ à 50 Hz ≥ 5 µC/cm².

3. Procédé selon la revendication 1, caractérisé en ce qu'on utilise un PZT ayant une température de frittage ≤ 1050°C.

4. Procédé selon l'une des revendications 1 à 3, caractérisé en ce qu'on utilise un substrat en oxyde d'aluminium comme matériau de support de la couche de titanate - zirconate de plomb.
